(19) 

Europäisches
Patentamt
European
Patent Office
Office européen
des brevets

(11)  **EP 2 267 908 A1**

(12)  # EUROPEAN PATENT APPLICATION
published in accordance with Art. 153(4) EPC

(43) Date of publication:
**29.12.2010 Bulletin 2010/52**

(21) Application number: **09732933.8**

(22) Date of filing: **16.04.2009**

(51) Int Cl.:
**H04B 1/26** *(2006.01)*    **H04N 5/46** *(2006.01)*

(86) International application number:
**PCT/JP2009/001748**

(87) International publication number:
**WO 2009/128267 (22.10.2009 Gazette 2009/43)**

(84) Designated Contracting States:
**AT BE BG CH CY CZ DE DK EE ES FI FR GB GR
HR HU IE IS IT LI LT LU LV MC MK MT NL NO PL
PT RO SE SI SK TR**
Designated Extension States:
**AL BA RS**

(30) Priority: **17.04.2008 JP 2008107656
25.09.2008 JP 2008245822**

(71) Applicant: **Panasonic Corporation
Kadoma-shi
Osaka 571-8501 (JP)**

(72) Inventors:
 • **UMEDA, Takashi
   1-61, Shiromi 2-chome, Chuo-ku
   Osaka-shi, Osaka 540-6207 (JP)**
 • **OZEKI, Hiroaki
   1-61, Shiromi 2-chome, Chuo-ku
   Osaka-shi, Osaka 540-6207 (JP)**
 • **WADA, Yosuke
   1-61, Shiromi 2-chome, Chuo-ku
   Osaka-shi, Osaka 540-6207 (JP)**
 • **FUJII, Takeshi
   1-61, Shiromi 2-chome, Chuo-ku
   Osaka-shi, Osaka 540-6207 (JP)**

(74) Representative: **Kügele, Bernhard et al
Novagraaf International SA
Avenue du Pailly 25
1220 Les Avanchets-Genève (CH)**

(54)  **RECEPTION DEVICE AND ELECTRONIC DEVICE USING THE SAME**

(57)    Provided is a reception device that selectively receives an analog broadcast signal and a digital broadcast signal. The reception device includes: an oscillation unit operable to output an oscillator signal; a frequency conversion unit operable to output an IF (Intermediate Frequency) signal group based on the oscillator signal outputted from the oscillation unit and a reception signal; a filter unit connected to an output side of the frequency conversion unit; and a control unit operable to control a frequency of the oscillator signal outputted from the oscillation unit. The control unit controls: the frequency of the oscillator signal to be within a reception frequency band when receiving the digital broadcast signal; and the frequency of the oscillator signal to be outside the reception frequency band when receiving the analog broadcast signal. With this configuration, it is possible to improve reception quality when receiving an analog broadcast signal.

FIG. 1

EP 2 267 908 A1

**Description**

TECHNICAL FIELD

The present invention relates to a reception device capable of selectively receiving an analog broadcast signal and a digital broadcast signal and to an electronic device using the same.

BACKGROUND ART

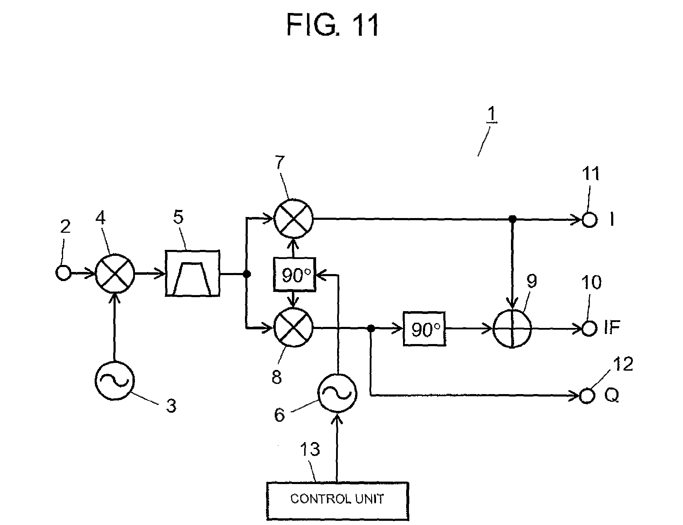

The following describes a conventional reception device that is disclosed in Patent Document 1 with reference to FIG. 11. FIG. 11 is a block diagram illustrating a conventional reception device. Referring to FIG. 11, conventional reception device 1 is a reception device that selectively receives an analog broadcast signal and a digital broadcast signal. Reception device 1 is provided with input terminal 2 connected to an antenna (not shown), and frequency conversion unit 4 that up-converts a frequency of an input signal from input terminal 2 based on an input from oscillation unit 3 for up-conversion. Further, reception device 1 is provided with filter 5 connected to an output side of frequency conversion unit 4, and oscillation unit 6 that outputs a first local signal and a second local signal respectively having phases substantially perpendicular to each other. Moreover, reception device 1 is provided with first frequency conversion unit 7 that down-converts an output signal from filter 5 into a baseband signal or an IF (Intermediate Frequency) signal using the first local signal outputted from oscillation unit 6. Furthermore, reception device 1 is provided with second frequency conversion unit 8 that down-converts a reception signal into a baseband signal or an IF signal using the second local signal outputted from oscillation unit 6. Further, reception device 1 is provided with phase synthesis unit 9 that phase-shifts and synthesizes one of the signal outputted from first frequency conversion unit 7 and the signal outputted from second frequency conversion unit 8, and IF signal output terminal 10 connected to an output side of phase synthesis unit 9.

Moreover, reception device 1 is provided with I signal output terminal 11 connected between first frequency conversion unit 7 and phase synthesis unit 9 and Q signal output terminal 12 connected between second frequency conversion unit 8 and phase synthesis unit 9. Furthermore, reception device 1 is provided with control unit 13 that controls a frequency of the first local signal and the second local signal outputted from oscillation unit 6. When receiving the digital broadcast signal, control unit 13 controls the frequency of the first local signal and the second local signal to be a central frequency of a reception frequency band. With this, control unit 13 causes I signal output terminal 11 to output an I signal as a baseband signal and Q signal output terminal 12 to output a Q signal as a baseband signal. On the other hand, when receiving the analog broadcast signal, reception device 1 controls the frequency of the first local signal and the second local signal to be a frequency that is (central frequency of the reception frequency band ± IF frequency), and causes IF signal output terminal 10 to output the IF signal.

With such a configuration, it is possible to remove an image disturbing signal for reception device 1 that selectively receives the analog broadcast signal and the digital broadcast signal.

However, when receiving the analog broadcast signal, conventional reception device 1 illustrated in FIG. 11 uses filter 5 in order to remove an image signal generated by first frequency conversion unit 7 and second frequency conversion unit 8. Further, when receiving the analog broadcast signal, conventional reception device 1 uses an IF bandpass filter (not shown) connected to a subsequent stage of IF signal output terminal 10 in order to remove an adjacent disturbing signal.

Moreover, when receiving the digital broadcast signal, conventional reception device 1 uses an I signal low-pass filter (not shown) connected to a subsequent stage of I signal output terminal 11 and a Q signal low-pass filter (not shown) connected to a subsequent stage of Q signal output terminal 12 in order to remove an adjacent disturbing signal.

However, when receiving the analog broadcast signal, it is necessary to make attenuation properties of the IF bandpass filter connected to the subsequent stage of IF signal output terminal 10 steep in order to remove an adjacent disturbing signal. However, a problem has been noted that, as the attenuation properties of the IF bandpass filter become steeper, ripple characteristics or group delay characteristics, for example, of the IF bandpass filter are deteriorated. This consequently poses a problem of deterioration in reception quality of the reception device.

Patent Document 1: Unexamined Japanese Patent Publication No. H08-130690

DISCLOSURE OF THE INVENTION

The present invention aims to improve reception quality of a reception device that selectively receives an analog broadcast signal and a digital broadcast signal when receiving the analog broadcast signal.

A reception device according to the present invention is a reception device that selectively receives an analog broadcast signal and a digital broadcast signal. A reception device according to the present invention includes: an oscillation unit operable to output an oscillator signal; a frequency conversion unit operable to output an IF signal group based on the oscillator signal outputted from the oscillation unit and a reception signal; a filter unit connected to an output side of the frequency conversion unit; and a control unit operable to control a frequency of the oscillator signal outputted from the oscillation unit. Further, according to the reception device according to the present invention, the control unit controls: the frequency of the oscillator signal to be within a reception frequency band when receiving the digital broadcast signal; and the frequency of the oscillator signal to be outside the reception frequency band when receiving the analog broadcast signal.

With such a configuration, the present invention can improve the reception quality when receiving the analog broadcast signal.

BRIEF DESCRIPTION OF THE DRAWINGS

FIG. 1 is a block diagram illustrating a reception device according to Embodiment 1 of the present invention.
FIG. 2 is an illustrative diagram of the reception device according to this embodiment.
FIG. 3 is an illustrative diagram of the reception device according to this embodiment.
FIG. 4 is a block diagram illustrating another reception device according to this embodiment.
FIG. 5 is a block diagram illustrating a reception device according to Embodiment 2 of the present invention.
FIG. 6 is a block diagram illustrating another reception device according to this embodiment.
FIG. 7 is a block diagram illustrating a PLL in the reception device according to this embodiment.
FIG. 8 is a block diagram illustrating another PLL in the reception device according to this embodiment.
FIG. 9 is a block diagram illustrating yet another PLL in the reception device according to this embodiment.
FIG. 10 is a block diagram illustrating an electronic device according to Embodiment 3 of the present invention.
FIG. 11 is a block diagram illustrating a conventional reception device.

REFERENCE MARKS IN THE DRAWINGS

| | |
|---|---|
| 14, 114 | Reception Device |
| 15, 115 | Input Terminal |
| 16, 148 | Oscillator |
| 16A, 116A | Oscillation Unit |
| 17, 117, 141 | Phase Shifter |
| 18, 118 | First Frequency Converter |
| 19, 119 | First Filter |
| 20, 120 | Second Frequency Converter |
| 21, 121 | Second Filter |
| 22, 122 | Phase Synthesis Unit |
| 23, 123 | Output Terminal |
| 24, 124 | Control Unit |
| 34, 35, 134, 135 | A/D Converter |
| 36, 136 | D/A Converter |
| 116 | Phase Synchronizing Circuit |
| 137 | Reference Oscillator |
| 138 | First Mixer |
| 139 | Filter Unit |
| 140 | Second Mixer |
| 142 | Third Frequency Converter |
| 143 | Fourth Frequency Converter |
| 144, 144A, 144B | Frequency Divider/Multiplier |
| 146 | Comparator |
| 147 | Loop Filter |
| 149, 151 | Oscillator Signal Output Terminal |
| 150A, 150B | Frequency Divider |
| 154 | Reference Oscillation Divider |
| 201 | Electronic Device |

| 202 | Demodulator |
| 203 | Decoder |
| 204 | Display Unit |

PREFERRED EMBODIMENTS FOR CARRYING OUT OF THE INVENTION

Embodiment 1

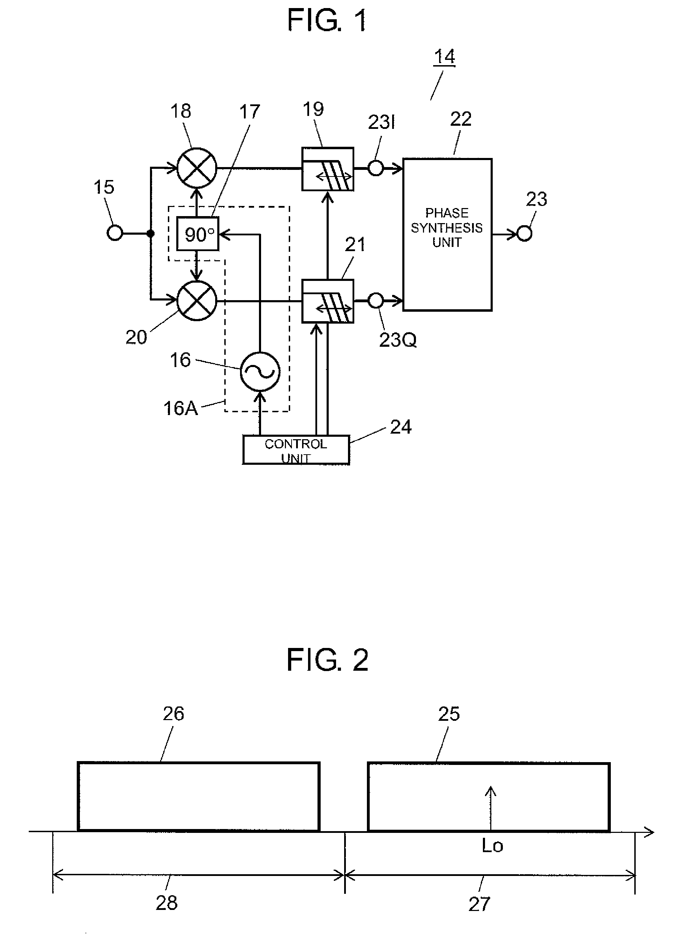

The following describes a high-frequency reception device according to Embodiment 1 of the present invention with reference to the drawings. FIG. 1 is a block diagram illustrating a reception device according to Embodiment 1 of the present invention.

Referring to FIG- 1, reception device 14 is a reception device that selectively receives an analog broadcast signal and a digital broadcast signal. Reception device 14 is provided with input terminal 15 to which a reception signal is inputted, oscillation unit 16 that outputs an oscillator signal, and phase shifter 17 that outputs a first local signal and a second local signal respectively having phases substantially perpendicular to each other using an output signal from oscillator 16. Further, reception device 14 is provided with first frequency converter 18 that down-converts, using the first local signal outputted from phase shifter 17, the reception signal inputted to input terminal 15 into a first IF signal that is a direct current signal or a signal with lower frequency around the direct current signal (hereinafter referred to as a baseband signal). Moreover, reception device 14 is provided with first filter 19 connected to an output side of first frequency converter 18. Furthermore, reception device 14 is provided with second frequency converter 20 that down-converts, using the second local signal outputted from phase shifter 17, the reception signal inputted to input terminal 15 into a second IF signal that is a baseband signal. The first IF signal and the second IF signal have phases substantially perpendicular to each other. Further, reception device 14 is provided with second filter 21 connected to an output side of second frequency converter 20. An example of first filter 19 and second filter 21 is a low-pass filter whose cutoff frequency is variable. As described above, according to this embodiment, oscillation unit 16A is configured by oscillator 16 and phase shifter 17. Further, according to this embodiment, an oscillator signal is configured by the first local signal and the second local signal. Moreover, according to this embodiment, a frequency conversion unit is configured by first frequency converter 18 and second frequency converter 20. Furthermore, an IF signal group is configured by the first IF signal and the second IF signal. Further, a filter unit is configured by first filter 19 and second filter 21.

Moreover, reception device 14 is provided with phase synthesis unit 22 that phase-shifts and synthesizes one or both of a signal outputted from first filter 19 and a signal outputted from second filter 21. Furthermore, reception device 14 is provided with output terminal 23 connected to an output side of phase synthesis unit 22. Reception device 14 may be provided with third frequency conversion unit (not shown) that is connected between phase synthesis unit 22 and output terminal 23, and that up-converts an output signal from the phase synthesis unit. With this, reception device 14 removes a disturbing signal using an IF filter (not shown) that is configured by such as a SAW (Surface Acoustic Wave) filter connected to an output side of the third frequency conversion unit.

Further, reception device 14 may be provided with other frequency conversion units (not shown) that are connected to previous or subsequent stages of first frequency converter 18 and second frequency converter 20 and convert a frequency of the input signal, and another filter (not shown) configured by such as an SAW filter that removes a disturbing signal.

Moreover, in order to compensate characteristics of first filter 19 and second filter 21 and to reduce a size and a current of the circuit, first frequency converter 18 and second frequency converter 20 may be configured by a frequency converter circuit having filter properties. Furthermore, the filter properties may be variable between digital broadcasting reception and analog broadcasting reception.

Further, according to this embodiment, first filter 19 and second filter 21 are described to have low-pass properties as an example, but first filter 19 and second filter 21 may have bandpass properties when receiving the analog broadcast signal. In this case, it is possible to control only the high-pass cutoff frequency to be kept high. Alternatively, it is possible to control both the low-pass and the high-pass cutoff frequencies to be kept high.

Further, reception device 14 is provided with control unit 24 that controls a frequency of the first local signal and the second local signal outputted from phase shifter 17. When reception device 14 receives the digital broadcast signal, control unit 24 controls the frequency of the first local signal and the second local signal to be kept within a reception frequency band. In other words, when the reception frequency band is 6 MHz, control unit 24 controls oscillation unit 16 so that an absolute value | RF-Lo | of a difference between frequency RF of the reception signal inputted into input terminal 15 and frequency Lo of the first local signal and the second local signal is kept within 6 MHz. Specifically, control unit 24 can controls frequency Lo of the first local signal and the second local signal by setting a dividing ratio to a phase synchronizing circuit (hereinafter referred to as the PLL (Phase Locked Loop)) that is included in oscillation unit 16. With this, control unit 24 causes first frequency converter 18 to output the first IF signal as the baseband signal and second frequency converter 20 to output the second IF signal as the baseband signal, and causes phase synthesis unit 22 to synthesize these signals. On the other hand, when reception device 14 receives the analog broadcast signal, the frequency of the first local signal and the second local signal are controlled to be kept outside the reception frequency band (that is, within an adjacent frequency band excluding a border between the reception frequency band and the adjacent frequency band). With this, control unit 24 causes first frequency converter 18 and second frequency converter 20 to output the signals with the frequency of the difference between the reception frequency band and the local signals, and causes phase synthesis unit 22 to synthesize these signal. Thus, with reception device 14 that selectively receives the analog broadcast signal and the digital broadcast signal, it is possible to remove an image disturbing signal both when receiving a digital broadcasting and when receiving an analog broadcasting.

The following describes a control by control unit 24 in detail with reference to the drawings. First, a case in which reception device 14 receives a digital broadcast signal is described with reference to FIG. 2. FIG. 2 is a diagram showing a frequency distribution of reception signal 25 and adjacent signal 26. Reception signal 25 is present within reception frequency band 27, and adjacent signal 26 is present within adjacent frequency band 28. When receiving the digital broadcast signal, control unit 24 controls frequency Lo of the first local signal and the second local signal to be kept within reception frequency band 27. With this, it is possible to keep frequency Lo lower than the cutoff frequency of first filter 19 and second filter 21. As a result, it is possible to improve attenuation of adjacent signal 26 for first filter 19 and second filter 21. Examples of adjacent signal 26 include a digital broadcast signal and an analog broadcast signal.

Further, when the frequency of the first local signal and the second local signal is a central frequency of reception frequency band 27, it is possible to further lower the cutoff frequency of first filter 19 and second filter 21. As a result, it is possible to further improve attenuation of adjacent signal 26 for first filter 19 and second filter 21. Further, as the digital broadcast signal has higher tolerability to a DC offset spurious in first frequency converter 18 and second frequency converter 20 than the analog broadcast signal, it is possible to set frequency Lo of the first local signal and the second local signal to be within reception frequency band 27.

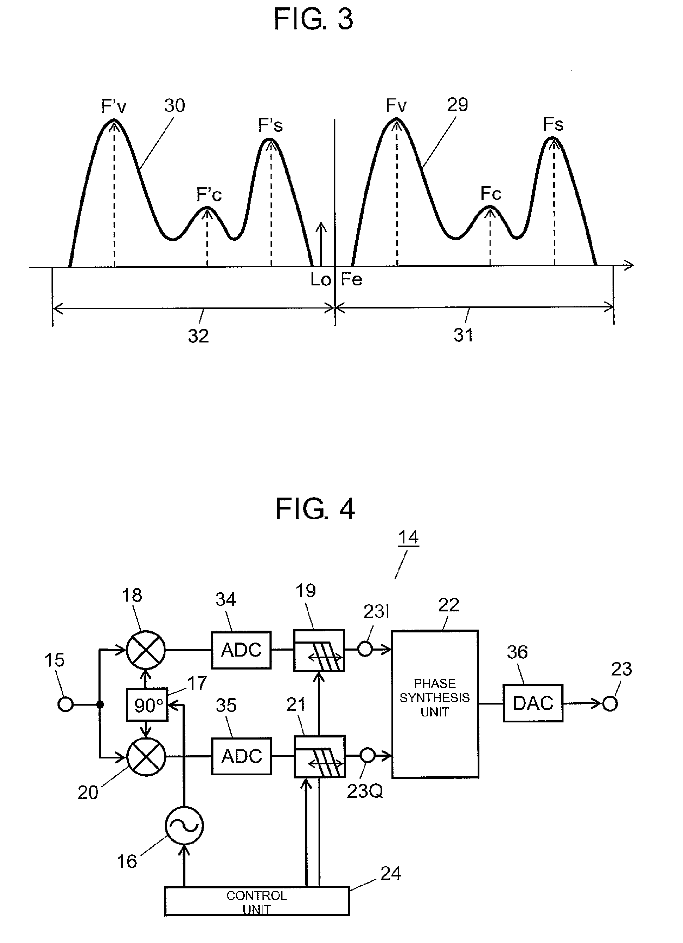

Next, a case in which reception device 14 receives an analog broadcast signal is described with reference to FIG. 3. FIG. 3 is a diagram showing a frequency distribution of reception signal 29 and adjacent signal 30. Reception signal 29 is present within reception frequency band 31, and adjacent signal 30 is present within adjacent frequency band 32. When receiving the analog broadcast signal, control unit 24 controls frequency Lo of the first local signal and the second local signal to be kept within adjacent frequency band 32 excluding border frequency Fe between reception frequency band 31 and adjacent frequency band 32. When the frequency of the first local signal and the second local signal is border frequency Fe, and if there is a digital broadcast signal as the adjacent signal, a noise due to image folding appears as a problem. Therefore, frequency Lo of the first local signal and the second local signal is controlled to be within adjacent frequency band 32 excluding border frequency Fe between reception frequency band 31 and adjacent frequency band 32. With this, it is possible to reduce an amount of the noise due to image folding. Further, when the frequency of the first local signal and the second local signal is border frequency Fe, secondary artifacts is generated in the vicinity of the direct current due to imbalance of a semiconductor device that constitutes the reception device. Therefore, it is possible to prevent deterioration in reception quality due to secondary artifacts by controlling the frequency of the first local signal and the second local signal to be within adjacent frequency band 32 excluding border frequency Fe between reception frequency band 31 and adjacent frequency band 32.

The analog broadcast signal has lower tolerability to the DC offset spurious in first frequency converter 18 and second frequency converter 20 than the digital broadcast signal. Therefore, it is possible to improve reception quality by control unit 24 setting frequency Lo of the first local signal and the second local signal to be outside reception frequency band 31 when receiving the analog broadcast signal.

Specifically, as the analog broadcast signal has lower tolerability to the spurious within the reception signal band frequency than the digital broadcast signal, such a spurious is detected as disturbance in a playback video if present. In contrast, in the case of the digital broadcast signal, a bit error rate can be improved by error correction and the like even when there is any spurious present, and accordingly, a spurious that is smaller than a predetermined level may not be easily detected as disturbance in a playback video.

Further, when receiving the analog broadcasting, control unit 24 controls the first local signal and the second local signal so that their frequency departs from the reception frequency band by a width of the frequency of adjacent frequency band 32 at maximum. With this, the frequency of the signals inputted to first filter 19 and second filter 21 is kept low. Specifically, it is possible to reduce the cutoff frequency of first filter 19 and second filter 21 in the analog reception. As a result, attenuation properties required for an IF bandpass filter (not shown) connected to a subsequent stage of output terminal 23 of the IF signal can be reduced. Alternatively, without using the IF bandpass filter, it is possible to obtain sufficient adjacent disturbance removal properties when receiving the analog broadcasting, using first filter 19 and second filter 21. With this, it is possible to improve reception quality of the reception device that selectively receives the analog broadcast signal and the digital broadcast signal.

As described above, reception device 14 according to this embodiment uses first filter 19 and second filter 21 that are used when receiving the digital broadcasting in order to remove the disturbing signal when receiving the analog broadcasting, thereby improving reception quality.

Further, control unit 24 may control the cutoff frequency of first filter 19 and second filter 21 to be a first frequency when receiving the digital broadcast signal, and may control the cutoff frequency of first filter 19 and second filter 21 to be a second frequency that is higher than the first frequency when receiving the analog broadcast signal. With this, it is possible to remove adjacent disturbance appropriately depending on whether the reception is of the digital broadcast signal or of the analog broadcasting.

It is desirable that, when reception device 14 receives the analog broadcast signal as shown in FIG. 3, control unit 24 controls frequency Lo of the first local signal and the second local signal to be a frequency below reception frequency band 31.

The reason of this is described below. In general, the analog broadcast signal includes video carrier frequency Fv, color subcarrier frequency Fc, and sound carrier frequency Fs in ascending order of the frequency. Further, such as ripple characteristics and group delay characteristics of a sound signal required for first filter 19 and second filter 21 are low, as compared to a video signal. Therefore, control unit 24 can set the cutoff frequency of first filter 19 and second filter 21 low by controlling frequency Lo of the first local signal and the second local signal to be below reception frequency band 31. Specifically, it is possible to improve the adjacent disturbance removal properties of first filter 19 and second filter 21. Further, when the analog broadcast signal includes sound carrier frequency Fs, color subcarrier frequency Fc, and video carrier frequency Fv in ascending order of the frequency, it is desirable by contrast that control unit 24 controls frequency Lo of the first local signal and the second local signal to be above reception frequency band 31. Specifically, when reception device 14 receives the analog broadcast signal, control unit 24 controls the first local signal and the second local signal to be outside reception frequency band 31 on a side closer to the video carrier frequency of reception frequency band 31.

Further, reception device 14 may be provided with first signal output terminal 23I connected between first filter 19 and phase synthesis unit 22, and second signal output terminal 23Q connected between second filter 21 and phase synthesis unit 22. In this case, when receiving the digital broadcasting, the first IF signal as the output signal of first filter 19 is outputted from first signal output terminal 23I, and the second IF signal as the output signal of second filter 21 is outputted from second signal output terminal 23Q. With this, when receiving the digital broadcasting, phase synthesis unit 22 may be eliminated, thereby reducing power consumption of reception device 14.

Furthermore, first filter 19 and second filter 21 may be a digital filter. In this case, as shown in FIG. 4, reception device 14 is provided with first A/D (Analog/Digital) converter 34 connected between first frequency conversion unit 18 and first filter 19. Further, reception device 14 is provided with second A/D converter 35 connected between second frequency conversion unit 20 and second filter 21. Moreover, reception device 14 is provided with D/A (Digital/Analog) converter 36 connected between phase synthesis unit 22 and output terminal 23. First signal output terminal 23I is connected to an output side of first filter 19. Likewise, second signal output terminal 23Q is connected to an output side of second filter 21. With this, it is possible to further downsize first filter 19 and second filter 21.

Embodiment 2

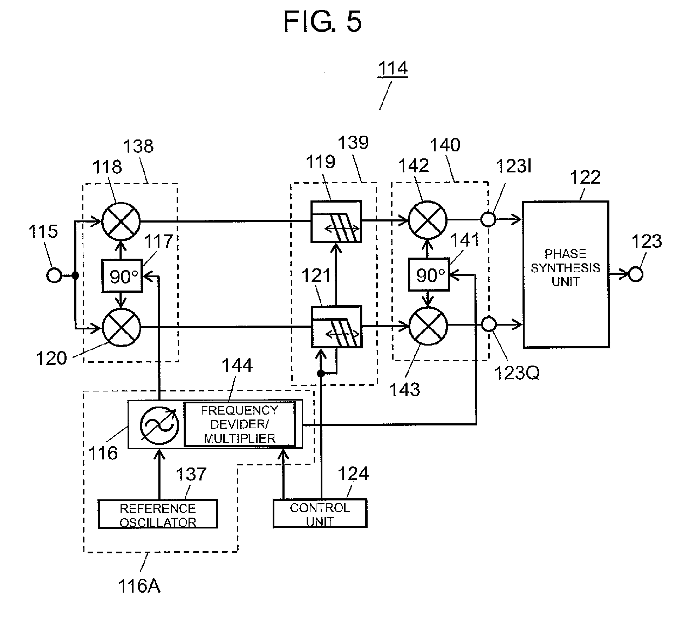

Next, the following describes a high-frequency reception device using a phase synchronizing circuit according to Embodiment 2 of the present invention with reference to the drawings. FIG. 5 is a block diagram illustrating a reception device according to Embodiment 2 of the present invention.

Referring to FIG. 5, reception device 114 is a reception device that selectively receives the analog broadcast signal and the digital broadcast signal. Reception device 114 is provided with input terminal 115, and PLL 116 that generates an oscillator signal based on a reference signal outputted from reference oscillator 137. Oscillation unit 116A includes reference oscillator 137 and PLL 116. Further, reception device 114 is provided with first mixer (frequency conversion unit) 138 that outputs an IF signal group based on a reception signal inputted to input terminal 115 and the oscillator signal. Moreover, reception device 114 is provided with filter unit 139 connected to an output side of first mixer 138. Furthermore, reception device 114 is provided with second mixer (another frequency conversion unit) 140 that outputs another IF signal group based on a signal outputted from filter unit 139 and another oscillator signal obtained by dividing or multiplying the oscillator signal using frequency divider/multiplier 144 of PLL 116. Further, reception device 114 is provided with control unit 124 that controls frequency of the first oscillator signal and the second oscillator signal outputted from PLL 116.

With such a configuration, even when a configuration in which first mixer 138 and second mixer 140 are connected in two stages is employed, it is not necessary to provide large-sized oscillation unit 116A for each mixer. Specifically, by providing frequency divider/multiplier 144, the oscillator signal and the other oscillator signal can be generated using common oscillation unit 116A, thereby reducing the size of the circuit to a large extent.

First mixer 138 is provided with phase shifter 117a that outputs first local signal and a second local signal respectively having phases substantially perpendicular to each other at a phase difference of 90 degrees based on the oscillator signal outputted from PLL 116. Further, first mixer 138 is provided with first frequency converter 118 that down-converts, using the first local signal outputted from phase shifter 117, a reception signal inputted to input terminal 115 into a first IF signal. Moreover, first mixer 138 is provided with second frequency converter 120 that down-converts, using the second local signal outputted from phase shifter 117, the reception signal inputted to input terminal 115 into a second IF signal. The first IF signal and the second IF signal have phases substantially perpendicular to each other. As described above, first mixer 138 outputs the IF signal group configured by the first IF signal and the second IF signal.

Filter unit 139 is provided with first filter 119 connected to an output side of first frequency converter 118 and second filter 121 connected to an output side of second frequency converter 120. An example of first filter 119 and second filter 121 is a low-pass filter whose cutoff frequency is variable.

Second mixer 140 is provided with third frequency converter 142 that up-converts a signal outputted from PLL 116 into a third IF signal of a frequency that is higher than that of the first IF signal. Further, second mixer 140 is provided with fourth frequency converter 143 that up-converts, using a fourth local signal outputted from phase shifter 141, a signal outputted from second filter 121 into a fourth IF signal of a frequency that is higher than that of the second IF signal. As described above, second mixer 140 outputs the other IF signal group configured by the third IF signal and the fourth IF signal.

Further, reception device 114 is provided with phase synthesis unit 122 that phase-shifts and synthesizes one or both of the third IF signal outputted from third frequency converter 142 and the fourth IF signal outputted from fourth frequency converter 143, thereby removing an image disturbing signal. Moreover, reception device 114 is provided with output terminal 123 connected to an output side of phase synthesis unit 122. It should be appreciated that reception device 114 may remove the disturbing signal using an IF filter (not shown) configured by such as an SAW filter connected to an output side of output terminal 123.

Further, in order to compensate characteristics of first filter 119 and second filter 121 and to reduce a size and a current of the circuit, first frequency conversion unit 118 and second frequency converter 120 may be configured by a frequency converter circuit having filter properties. Moreover, the filter properties can be variable between the digital broadcasting reception and the analog broadcasting reception. Furthermore, according to this embodiment, filter unit 139 is described to have low-pass properties as an example, but filter unit 139 may have bandpass properties when receiving the analog broadcast signal. In this case, it is possible to control only the high-pass cutoff frequency to be kept high. Alternatively, it is possible to control both the low-pass and the high-pass cutoff frequency to be kept high.

The following describes a control by control unit 124 in detail. First, a case in which reception device 114 receives a digital broadcast signal is described. When reception device 114 receives the digital broadcast signal, control unit 124 controls the frequency of the oscillator signal to be kept within the reception frequency band. Further, control unit 124 causes first frequency converter 118 to output the first IF signal and second frequency converter 120 to output the second IF signal whose phase is delayed by 90 degrees from the first IF signal. Then, control unit 124 causes second mixer 140 to frequency-convert, using the other oscillator signal that has been obtained by dividing or multiplying the first oscillator signal, a signal obtained by filtering the first IF signal by first filter 119 and a signal obtained by filtering the second IF signal by second filter 121 respectively into the third IF signal and the fourth IF signal.

Similarly to the example described according to Embodiment 1, when receiving the digital broadcast signal, control unit 124 controls, as shown in FIG. 2, frequency Lo of the oscillator signal to be kept within reception frequency band 27. With this, the cutoff frequency of first filter 119 and second filter 121 can be kept low. As a result, it is possible to improve attenuation of adjacent signal 26 in first filter 119 and second filter 121. Adjacent signal 26 is a disturbing signal, which is a digital broadcast signal or an analog broadcast signal, for example.

Further, when frequency Lo of the oscillator signal corresponds to reception signal 25, that is, the central frequency of reception frequency band 27, the cutoff frequency of first filter 119 and second filter 121 can be kept even lower. As a result, it is possible to further improve attenuation of adjacent signal 26 in first filter 119 and second filter 121. Further, the digital broadcast signal has higher tolerability to the DC offset spurious in first frequency converter 118 and second frequency converter 120 than the analog broadcast signal. Therefore, even if a spurious is present in the reception signal, a bit error rate can be improved by error correction and the like, and disturbance in the playback video may not be easily detected. Accordingly, it is possible to set frequency Lo of the oscillator signal to be within reception frequency band 27.

Next, a case in which reception device 114 receives an analog broadcast signal is described. When reception device 114 receives the analog broadcast signal, as in Embodiment 1, control unit 124 controls the frequency of the first oscillator signal to be kept outside reception frequency band 31 (that is, within adjacent frequency band 32 excluding a border between reception frequency band 31 and adjacent frequency band 32). Further, control unit 124 causes first frequency converter 118 and second frequency converter 120 to output the IF signal group (the first IF signal and the second IF signal) of a low frequency which is a difference between reception frequency band 31 and the oscillator signal. Then, control unit 124 causes second mixer 140 to frequency-convert, using the other oscillator signal that has been obtained by dividing or multiplying the oscillator signal, the IF signal group into the other IF signal group (the third IF signal and the fourth IF signal).

As shown in FIG. 3, when receiving the analog broadcast signal, control unit 124 controls frequency Lo of the oscillator signal to be kept within adjacent frequency band 32 excluding border frequency Fe between reception frequency band 31 and adjacent frequency band 32. When the frequency of the oscillator signal and the other oscillator signal is border frequency Fe, if there is an analog signal or a digital broadcast signal as the adjacent signal, a noise due to image folding appears as a problem. Therefore, frequency Lo of the oscillator signal is controlled to be within adjacent frequency band 32 excluding border frequency Fe between reception frequency band 31 and adjacent frequency band 32. With this, it is possible to reduce an amount of the noise due to image folding. Further, when frequency Lo of the oscillator signal is border frequency Fe, secondary artifacts is generated in the vicinity of the direct current due to imbalance of a semiconductor device that constitutes reception device 114. Therefore, frequency Lo of the oscillator signal is controlled to be within adjacent frequency band 32 excluding border frequency Fe between reception frequency band 31 and adjacent frequency band 32. With this, it is possible to prevent deterioration in reception quality due to secondary artifacts.

The analog broadcast signal has lower tolerability to the DC offset spurious in first frequency converter 118 and second frequency converter 120 than the digital broadcast signal. Therefore, it is possible to improve reception quality by control unit 124 setting frequency Lo of the oscillator signal to be outside reception frequency band 31 when receiving the analog broadcast signal.

Specifically, as the analog broadcast signal has lower tolerability to the spurious within the reception signal band frequency than the digital broadcast signal, such a spurious is detected as disturbance in a playback video if present. In contrast, in the case of the digital broadcast signal, a bit error rate can be improved by error correction and the like even when there is any spurious present, and accordingly, a spurious that is smaller than a predetermined level may not be easily detected as disturbance in a playback video.

Further, when receiving the analog broadcasting, control unit 124 causes frequency Lo of the oscillator signal to depart from the reception frequency band by the width of the frequency of adjacent frequency band 32 at maximum. With this, the frequency of the signals inputted to first filter 119 and second filter 121 is kept low. Specifically, it is possible to reduce the cutoff frequency of first filter 119 and second filter 121 when receiving the analog broadcasting. As a result, attenuation properties required for an IF bandpass filter (not shown) connected to a subsequent stage of output terminal 123 of the IF signal can be reduced. Alternatively, it is possible to obtain sufficient adjacent disturbance removal properties without using the IF bandpass filter, by using first filter 119 and second filter 121, when receiving the analog broadcasting. With this, it is possible to improve reception quality of reception device 114 that selectively receives the analog broadcast signal and the digital broadcast signal.

As described above, reception device 114 according to this embodiment uses first filter 119 and second filter 121 that are used when receiving the digital broadcasting in order to remove the disturbing signal when receiving the analog broadcasting. Therefore, it is possible to improve reception quality when receiving the analog broadcasting.

Further, control unit 124 may control the cutoff frequency of first filter 119 and second filter 121 to be a first frequency when receiving the digital broadcast signal, and may control the cutoff frequency of first filter 119 and second filter 121 to be a second frequency that is higher than the first frequency when receiving the analog broadcast signal. With this, it is possible to remove adjacent disturbance appropriately depending on whether the reception is of the digital broadcast signal or of the analog broadcasting.

It is desirable that, when reception device 114 receives the analog broadcast signal as shown in FIG. 3, control unit 124 controls frequency Lo of the first oscillator signal to be a frequency below reception frequency band 31. The reason of this is the same as that in Embodiment 1. Specifically, in general, the analog broadcast signal includes video carrier frequency Fv, color subcarrier frequency Fc, and sound carrier frequency Fs in ascending order of the frequency. Further, such as ripple characteristics and group delay characteristics of a sound signal required for first filter 119 and second filter 121 are low, as compared to a video signal. Therefore, control unit 124 can set the cutoff frequency of first filter 119 and second filter 121 low by controlling frequency of the first local signal and the second local signal to be below reception frequency band 31. Specifically, it is possible to improve the adjacent disturbance removal properties of first filter 119 and second filter 121. On the other hand, when the analog broadcast signal includes sound carrier frequency Fs, color subcarrier frequency Fc, and video carrier frequency Fv in ascending order of the frequency, it is desirable by contrast that control unit 124 controls frequency Lo of the oscillator signal to be a frequency above reception frequency band 31. Specifically, when reception device 114 receives the analog broadcast signal, control unit 124 controls the first local signal and the second local signal to be outside reception frequency band 31 on a side closer to the video carrier frequency of reception frequency band 31.

Further, reception device 114 may be provided with third signal output terminal 123I connected between third frequency converter 142 and phase synthesis unit 122, and fourth signal output terminal 123Q connected between fourth frequency converter 143 and phase synthesis unit 22. In this case, when receiving the digital broadcasting, the third IF signal is outputted from third signal output terminal 123I and fourth IF signal is outputted from fourth signal output terminal 123Q. Further, reception device 114 may be connected with a digital demodulator (not shown) to which the third IF signal and the fourth IF signal are inputted. With this, when receiving the digital broadcasting, phase synthesis unit 22 may be eliminated, thereby reducing power consumption of reception device 14.

Further, reception device 114 carry out the frequency conversion using the signals outputted from a single PLL 116 without using two mixers. With this, it is possible to downsize the reception device.

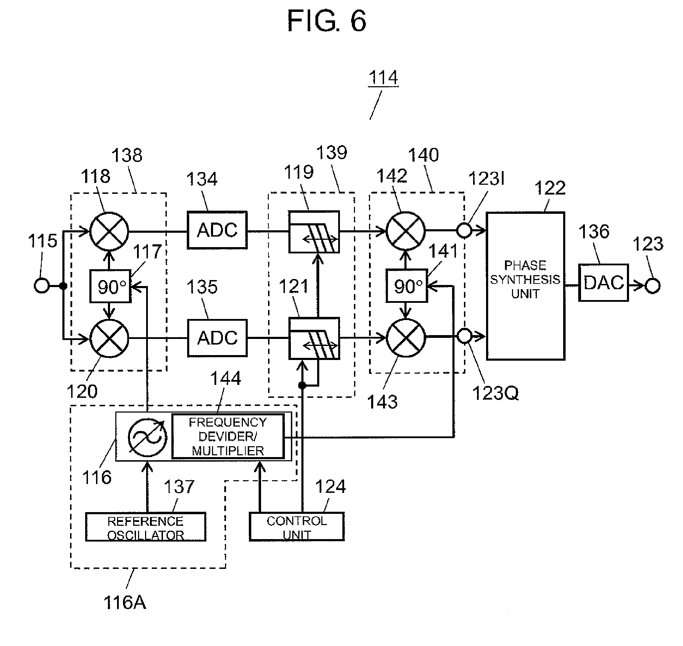

First filter 119 and second filter 121 according to this embodiment can be a digital filter. In this case, as shown in FIG. 6, reception device 114 is provided with first A/D converter 134 connected between first frequency converter 118 and first filter 119. Further, reception device 114 is provided with second A/D converter 135 connected between second frequency converter 120 and second filter 121. Moreover, reception device 114 is provided with D/A converter 136 connected between phase synthesis unit 122 and output terminal 123. With this, as it is possible to configure first filter 119 and second filter 121 by active devices using finer semiconductor fabrication, further downsizing is realized.

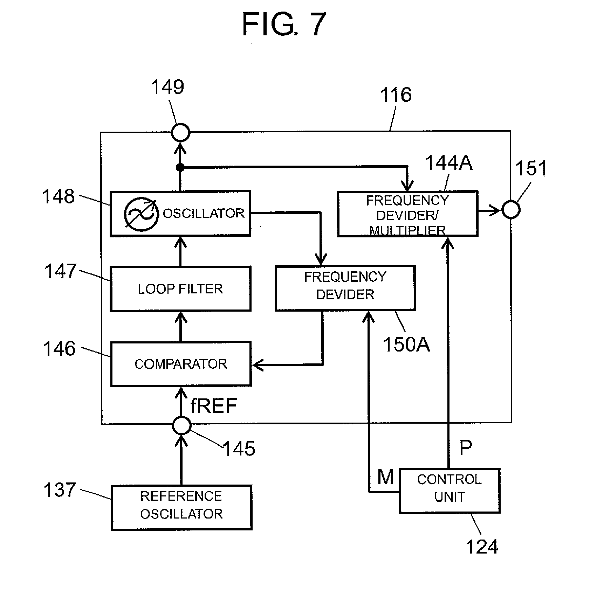

Next, a configuration of PLL 116 is described with reference to FIG. 7 to FIG. 9. Referring FIG. 7, PLL 116 is provided with comparator 146 to which a reference signal is inputted, and loop filter 147 connected to an output side of comparator 146. Further, PLL 116 is provided with oscillator 148 connected to an output side of loop filter 147. Oscillator 148 generates the oscillator signal and outputs the oscillator signal to first mixer 138 via oscillator signal output terminal 149. Further, PLL 116 is provided with frequency divider 150A connected between another output of oscillator 148 and another input of comparator 146. Moreover, PLL 116 is provided with frequency divider/multiplier 144A connected between oscillator 148 and second mixer 140. Frequency divider/multiplier 144A outputs the other oscillator signal obtained by dividing or multiplying the oscillator signal to second mixer 140 via oscillator signal output terminal 151. Here, dividing ratio M set for frequency divider 150A (M is an integer or decimal number) and dividing/multiplying ratio P set for frequency divider/multiplier 144A (P is an integer or decimal number) are controlled by control unit 124.

In this configuration, where a frequency of the reference signal is fREF, a frequency of the oscillator signal is fLO1, and a frequency of the other oscillator signal is fL02, comparator 146 outputs a pulse signal that is in proportion to a phase difference between two frequencies of inputted fREF and fLO1/M. Loop filter 147 outputs a voltage signal obtained by lowpass filtering a pulse signal outputted from comparator 146. In a situation in which the voltage signal is converged to a certain voltage, oscillator 148 outputs stable frequency fLO1 as the first oscillator signal. With such a loop configuration, fLO1 and fL02 are respectively expressed by formula 1 and formula 2.

$$fLO1 = fREF \times M \qquad \text{Formula 1}$$

$$fLO2 = fLO1/P = fREF \times M/P \qquad \text{Formula 2}$$

Now, a specific example of operation is shown by numbers when reference signal fREF is taken as 4 MHz in FIG. 7. When reception device 114 receives the digital broadcast signal, assuming that the reception frequency band is from 500 MHz to 506 MHz (18 channels in terrestrial broadcasting within Japan), the IF signal group is 0 MHz, and the other IF signal group is 10 MHz, oscillator signal fLO1 is 503 MHz (= a central frequency of the reception frequency band), and the other oscillator signal fL02 is 10 MHz. Therefore, dividing ratio M controlled by control unit 124 is 125.75 (= 503 MHz/4 MHz), and dividing/multiplying ratio P is 50.3 (= 503 MHz/10 MHz).

On the other hand, when receiving the analog broadcast signal, assuming that the reception frequency band is from 506 MHz to 512 MHz (19 channels in terrestrial broadcasting within Japan), the IF signal group is 3.5 MHz, and the other IF signal group is 10 MHz, oscillator signal fLO1 is 505.5 MHz (= lower 0.5 MHz of the reception frequency band), and the other oscillator signal fLO2 is 13.5 MHz. Therefore, dividing ratio M controlled by control unit 124 is 126.375 (= 505.5 MHz/4 MHz), and dividing/multiplying ratio P is 37.444 ($\approx$ 505.5 MHz/13.5 MHz).

For frequency divider 150A and frequency divider/multiplier 144A, a fractional-N method, a delta-sigma method or the like is employed for fractional frequency division. By using such a method, it is possible to dramatically decrease resolution set for fLO1 and fLO2.

With such a configuration, the other oscillator signal according to this embodiment is generated by dividing and multiplying the oscillator signal generated by single PLL 116. Therefore, a VCO (Voltage Controlled Oscillator) included in PLL 116 may not be additionally provided in order to generate the other oscillator signal. Specifically, it is possible to use dividing/multiplying circuit (logic circuit) realizing size reduction to a large extent as semiconductor fabrication becomes finer, thereby downsizing the reception device.

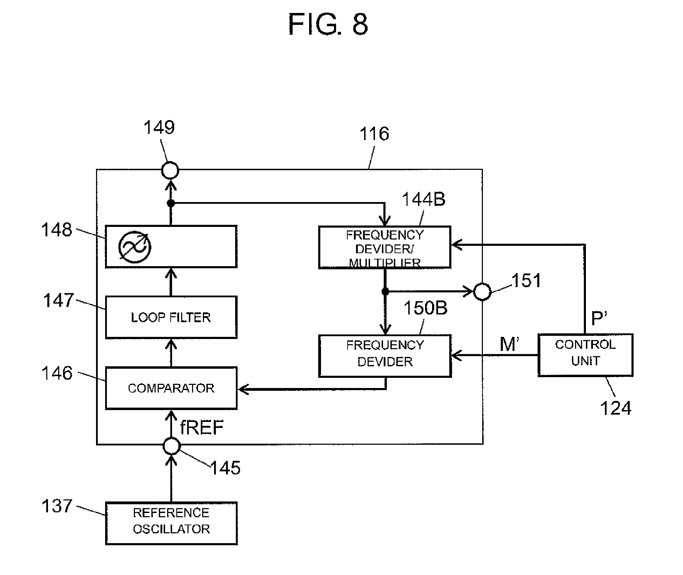

FIG. 8 is a block diagram illustrating PLL 116 of a different configuration as that shown in FIG. 7. Referring to FIG. 8, PLL 116 is provided with comparator 146 to which a reference signal is inputted, and loop filter 147 connected to an output side of comparator 146. Further, PLL 116 is provided with oscillator 148 connected to an output side of loop filter 147. Oscillator 148 generates the first oscillator signal and outputs the oscillator signal to first mixer 138 via oscillator signal output terminal 149. Further, PLL 116 is provided with frequency divider 150B connected between another output of oscillator 148 and another input of comparator 146. Moreover, PLL 116 is provided with frequency divider/multiplier 144B connected in series between oscillator 148 and frequency divider 150B. Frequency divider/multiplier 144B outputs the other oscillator signal obtained by dividing or multiplying the oscillator signal via oscillator signal output terminal 151.

Here, dividing ratio M' set for frequency divider 150B and dividing/multiplying ratio P' set for frequency divider/multiplier 144B are controlled by control unit 124. In the configuration shown in FIG. 8, fLO1 and fLO2 are respectively expressed by formula 3 and formula 4.

$$fLO1=fREF\times M'\times P' \qquad \text{Formula 3}$$

$$fLO2=fLO1\,/P'=fREF\times M' \qquad \text{Formula 4}$$

Now, a specific example of operation is shown by numbers when reference signal fREF is taken as 4 MHz in FIG. 8. Here, dividing ratio M' and dividing/multiplying ratio P' set by control unit 124 are derived on the same condition as described with reference to FIG. 7.

When reception device 114 receives the digital broadcast signal (the reception frequency band: 500 MHz to 506 MHz, the IF signal group: 0 MHz, and the other IF signal group: 10 MHz), dividing ratio M' is 2.5 (= 10 MHz/4 MHz), and dividing/multiplying ratio P' is 50.3 (= 503 MHz/10 MHz).

On the other hand, when receiving the analog broadcast signal (the reception frequency band: 506 MHz to 512 MHz, the IF signal group: 3.5 MHz, and the other IF signal group: 10 MHz), dividing ratio M' is 3.375 (= 13.5 MHz/ 4 MHz), and dividing/multiplying ratio P' is 37.444 ($\approx$ 505.5 MHz/13.5 MHz).

Synthesize dividing ratio (= M'$\times$ P') when serially connecting dividing ratio M' and dividing/multiplying ratio P' set respectively for frequency divider 150B and frequency divider/multiplier 144B of the configuration shown in FIG. 8 in the looping structure of PLL 116 has the same function as that of dividing ratio M of frequency divider 150A shown in FIG. 7.

Specifically, with the configuration shown in FIG. 8, frequency divider/multiplier 144B is provided as a process of signal processing for generating the oscillator signal, instead of newly providing frequency divider/multiplier 144B in order to generate the other oscillator signal. Therefore, it is possible to make dividing ratio M' for frequency divider 144B relatively small, thereby downsizing the reception device.

In the examples of operation as described with reference to FIG. 7 and FIG- 8, the case in which frequency fREF of the reference signal is lower than the frequency of the other IF signal group is described. However, with such an operational condition, dividing ratio M (M') and dividing/multiplying ratio P (P') become 1 or greater, and it is not necessary for frequency dividers 150A and 150B and frequency divider/multipliers 144A and 144B to multiply the frequency. Specifically, frequency dividers 150A and 150B and frequency divider/multipliers 144A and 144B can be configured as a simple circuit that only carry out frequency division, thereby downsizing the reception device.

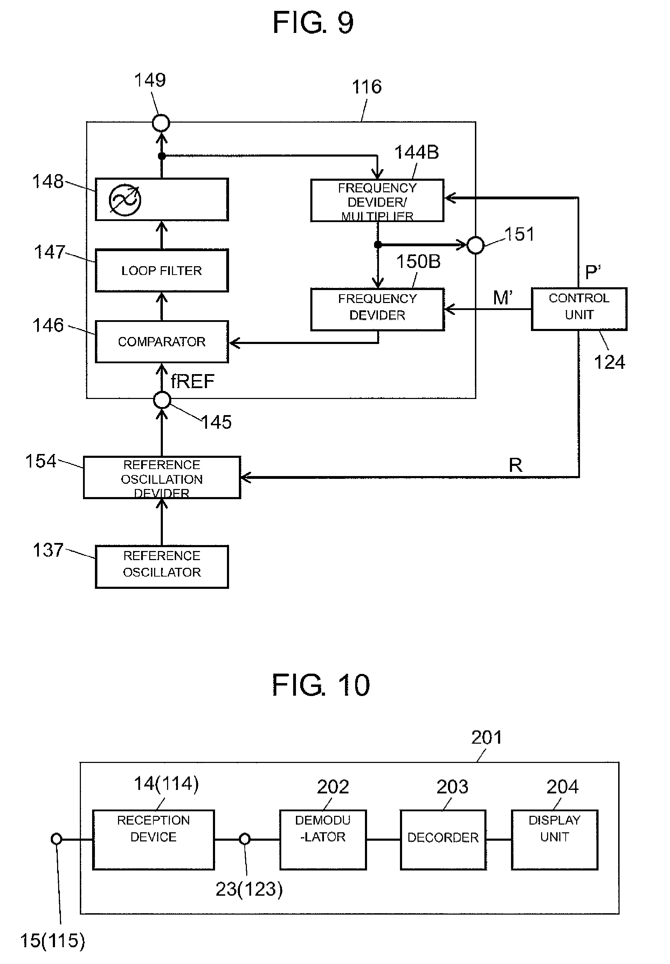

Next, FIG. 9 is a block diagram illustrating PLL 116 of a different configuration as that described with reference to FIG. 7 and FIG. 8. PLL 116 shown in FIG. 9 is provided with reference oscillation divider 154 connected between reference oscillator 137 and comparator 146 shown in FIG. 8. Reference oscillation dividing ratio R set for reference oscillation divider 154 is controlled by control unit 124. Then, reference oscillation divider 154 inputs reference signal fREF obtained by dividing the oscillation signal oscillated by reference oscillator 137 by R to comparator 146.

According to the configuration shown in FIG. 9, it is possible to increase the oscillation frequency of reference oscillator 137 while decreasing frequency fREF of the reference signal to be lower than the frequency of the other IF signal group. For example, when a crystal oscillator is used for reference oscillator 137, it is possible to downsize the reception device.

Embodiment 3

FIG. 10 is a block diagram illustrating an electronic device on which the reception device according to Embodiment 3 of the present invention is mounted. Referring to FIG. 10, electronic device 201 on which reception device 14, 114 described in Embodiment 1 or Embodiment 2 is mounted is provided with demodulator 202 connected to output terminal 23, 123, decoder 203 connected to an output side of demodulator 202, and display unit 204 connected to an output side of decoder 203.

Specifically, by mounting reception device 14, 114 that selectively receives the analog broadcast signal and the digital broadcast signal described in each embodiment to electronic device 201, it is possible to improve image quality of display unit 204, and to downsize electronic device 201.

INDUSTRIAL APPLICABILITY

According to the present invention, it is possible to improve reception quality of the reception device that selectively receives the analog broadcast signal and the digital broadcast signal when receiving an analog broadcast signal, and therefore, the present invention can be utilized in electronic devices, for example, such as televisions, car navigation systems for automobile use, and mobile terminals.

**Claims**

1.  A reception device that selectively receives an analog broadcast signal and a digital broadcast signal, the device comprising:

    an oscillation unit operable to output an oscillator signal;
    a frequency conversion unit operable to output an IF signal group based on the oscillator signal outputted from the oscillation unit and a reception signal;
    a filter unit connected to an output side of the frequency conversion unit; and
    a control unit operable to control a frequency of the oscillator signal outputted from the oscillation unit, wherein the control unit controls:

    the frequency of the oscillator signal to be within a reception frequency band when receiving the digital broadcast signal; and
    the frequency of the oscillator signal to be outside the reception frequency band when receiving the analog broadcast signal.

2.  The reception device according to claim 1, wherein
    the oscillation unit outputs the oscillator signal configured by a first local signal and a second local signal respectively having phases that are perpendicular to each other,
    the frequency conversion unit outputs the IF signal group including a first IF signal and a second IF signal,
    the frequency conversion unit includes:

    a first frequency converter operable to convert the reception signal into the first IF signal using the first local signal outputted from the oscillation unit; and
    a second frequency converter operable to convert the reception signal into the second IF signal using the second local signal outputted from the oscillation unit, and

    the filter unit includes:

    a first filter connected to an output side of the first frequency converter; and
    a second filter connected to an output side of the second frequency converter.

3.  The reception device according to claim 2, wherein
    the control unit controls a cutoff frequency of the first filter and the second filter,
    when receiving the digital broadcast signal, the control unit controls the cutoff frequency of the first filter and the second filter to be a first frequency, and
    when receiving the analog broadcast signal, the control unit controls the cutoff frequency of the first filter and the second filter to be a second frequency that is higher than the first frequency.

4.  The reception device according to claim 2, wherein
    when receiving the analog broadcast signal, the control unit controls a frequency of the first local signal and the second local signal to be a frequency within an adjacent frequency band.

5.  The reception device according to claim 2, wherein
    when receiving the analog broadcast signal, the control unit controls a frequency of the first local signal and the second local signal to be a frequency outside the reception frequency band on a side closer to a video carrier frequency in the reception frequency band.

6.  The reception device according to claim 2, wherein

when receiving the digital broadcast signal, the control unit controls a frequency of the first local signal and the second local signal to be a central frequency of the reception frequency band.

7. The reception device according to claim 2, further comprising:

   a phase synthesis unit operable to phase-shift and synthesize one or both of the signal outputted from the first filter and the signal outputted from the second filter.

8. The reception device according to claim 7, further comprising:

   a first signal output terminal connected to an output side of the first filter further; and a second signal output terminal connected to an output side of the second filter, wherein, when receiving the digital broadcast signal, the output signal from the first filter is outputted through the first signal output terminal and the output signal from the second filter is outputted through the second signal output terminal.

9. The reception device according to claim 1, further comprising:

   another frequency conversion unit connected to an output side of the filter unit, wherein
   the oscillation unit includes: a reference oscillator operable to output a reference signal; and a phase synchronizing circuit connected to the reference oscillator and provided with a frequency divider/multiplier,
   the oscillation unit outputs the oscillator signal based on the reference signal, and outputs another oscillator signal obtained by dividing or multiplying using the frequency divider/multiplier based on the reference signal, and
   the other frequency conversion unit outputs another IF signal group based on a signal outputted from the filter unit and the other oscillator signal.

10. The reception device according to claim 9, wherein
    the phase synchronizing circuit includes:

    a comparator to which the reference signal is inputted;
    an oscillator connected to an output side of the comparator and operable to output the oscillator signal; and
    a frequency divider connected between an output of the oscillator and another input of the comparator, wherein

    the frequency divider/multiplier is connected between the oscillator and the other frequency conversion unit.

11. The reception device according to claim 9, wherein
    the phase synchronizing circuit includes:

    a comparator to which the reference signal is inputted;
    an oscillator connected to an output side of the comparator and operable to output the oscillator signal; and
    a frequency divider connected to another input of the comparator, wherein

    the frequency divider/multiplier is connected between the oscillator and the frequency divider.

12. The reception device according to claim 9, wherein
    a frequency of the reference signal is lower than a frequency of the other IF signal group.

13. The reception device according to claim 12, further comprising:

    a reference oscillation divider connected between the reference oscillator and the comparator and operable to divide the signal outputted from the reference oscillator so as to output the reference signal whose frequency is lower than a frequency of the other IF signal group to the comparator.

14. The reception device according to claim 9, wherein
    the frequency conversion unit includes:

    a phase shifter operable to output a first local signal and a second local signal based on the oscillator signal, the first local signal and the second local signal having phases that are perpendicular to each other;
    a first frequency converter operable to convert the reception signal into a first IF signal using the first local signal;

and
a second frequency converter operable to convert the reception signal into a second IF signal using the second local signal, and

the filter unit includes:

a first filter connected to an output side of the first frequency converter; and
a second filter connected to an output side of the second frequency converter.

15. The reception device according to claim 14, wherein
the other frequency conversion unit includes:

a phase shifter operable to output a third local signal and a fourth local signal based on the other oscillator signal, third local signal and the fourth local signal having phases that are perpendicular to each other;
a third frequency converter operable to convert a signal outputted from the first filter and the third local signal into the third IF signal; and
a fourth frequency converter operable to convert a signal outputted from the second filter and the fourth local signal into the fourth IF signal, and

the other frequency conversion unit outputs the other IF signal group including the third IF signal and the fourth IF signal.

16. An electronic device comprising:

a reception device according to claim 1;
a demodulator connected to an output side of the reception device;
a decoder connected to an output side of the demodulator; and
a display unit connected to an output side of the decoder.

# FIG. 1

# FIG. 2

# FIG. 3

# FIG. 4

# FIG. 5

# FIG. 6

# FIG. 7

# FIG. 8

# FIG. 9

# FIG. 10

FIG. 11

## INTERNATIONAL SEARCH REPORT

| International application No. |
|---|
| PCT/JP2009/001748 |

A. CLASSIFICATION OF SUBJECT MATTER
*H04B1/26*(2006.01)i, *H04N5/46*(2006.01)i

According to International Patent Classification (IPC) or to both national classification and IPC

B. FIELDS SEARCHED

Minimum documentation searched (classification system followed by classification symbols)
H04B1/26, H04N5/46

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2009 |
| Kokai Jitsuyo Shinan Koho | 1971-2009 | Toroku Jitsuyo Shinan Koho | 1994-2009 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 08-139628 A  (Sharp Corp.),<br>31 May, 1996 (31.05.96),<br>Par. Nos. [0013] to [0019]; Fig. 2<br>(Family: none) | 1-16 |
| A | JP 2002-111525 A  (Matsushita Electric Industrial Co., Ltd.),<br>12 April, 2002 (12.04.02),<br>Par. Nos. [0018] to [0026]; Fig. 1<br>& US 2002/0065059 A1    & EP 1193858 A2<br>& DE 60116841 T         & CN 1347203 A | 1-16 |

☒ Further documents are listed in the continuation of Box C. ☐ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| 28 May, 2009 (28.05.09) | 09 June, 2009 (09.06.09) |

| Name and mailing address of the ISA/<br>   Japanese Patent Office | Authorized officer |
|---|---|
| Facsimile No. | Telephone No. |

Form PCT/ISA/210 (second sheet) (April 2007)

**INTERNATIONAL SEARCH REPORT**

International application No.

PCT/JP2009/001748

| C (Continuation). DOCUMENTS CONSIDERED TO BE RELEVANT | | |
|---|---|---|
| Category* | Citation of document, with indication, where appropriate, of the relevant passages | Relevant to claim No. |
| A | JP 63-244937 A (Deutsche ITT Industries GmbH), 12 October, 1988 (12.10.88), Page 5, lower left column, lines 8 to 17; Fig. 3 & US 4789897 A & EP 282607 A1 & DE 3764361 C & DE 3764361 D & CN 1035746 A | 5 |
| A | JP 2000-68752 A (Sharp Corp.), 03 March, 2000 (03.03.00), Par. No. [0033]; Fig. 2 (Family: none) | 7 |
| A | JP 2005-286529 A (Matsushita Electric Industrial Co., Ltd.), 13 October, 2005 (13.10.05), Par. Nos. [0032] to [0040]; Fig. 1 (Family: none) | 9-15 |

Form PCT/ISA/210 (continuation of second sheet) (April 2007)

**EP 2 267 908 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H08130690 B